Europäisches Patentamt

European Patent Office

Office européen des brevets

(19)

(11) Numéro de publication: **0 359 223**
**A1**

## (12) DEMANDE DE BREVET EUROPEEN

(21) Numéro de dépôt: 89116943.5

(22) Date de dépôt: 13.09.89

(51) Int. Cl.5 **H01R 23/72 , H05K 7/14**

(30) Priorité: 15.09.88 FR 8812038

(43) Date de publication de la demande:
21.03.90 Bulletin 90/12

(84) Etats contractants désignés:
**AT BE CH DE ES FR GB IT LI NL SE**

(71) Demandeur: **ALCATEL RADIOTELEPHONE**
**10, rue de la Baume**
**F-75008 Paris(FR)**

(72) Inventeur: **Bourdonnais, Serge**
**29h, rue Faidherbe**
**F-53000 Laval(FR)**

(74) Mandataire: **Weinmiller, Jürgen et al**
**Lennéstrasse 9 Postfach 24**
**D-8133 Feldafing(DE)**

(54) Contact électrique pour circuits imprimés équipés de composants montés en surface, et circuit imprimé comportant au moins un tel contact.

(57) La présente invention concerne un contact électrique (10) pour circuits imprimés (40) équipés de composants montés en surface (41), assurant une liaison électrique entre ce circuit et un circuit adjacent (50) ou un couvercle, caractérisé en ce qu'il est miniaturisé, sa surface d'emprise sur le circuit étant sensiblement égale à celle des composants (41).

Elle concerne également un circuit imprimé comportant au moins un tel contact.

# FIG.4

Contact électrique pour circuits imprimés équipés de composants montés en surface, et circuit imprimé comportant au moins un tel contact

La présente invention concerne un contact électrique pour circuits imprimés équipés de composants montés en surface, assurant une liaison électrique entre ce circuit et un circuit adjacent ou un couvercle.

Elle concerne également un circuit imprimé comportant au moins un tel contact.

Les circuits imprimés équipés de composants montés en surface tels que des résistances ou des condensateurs, comportent des contacts électriques assurant une liaison électrique avec un circuit adjacent ou un couvercle. D'une manière connue, les composants montés en surface sont déposés et brasés lors d'une première opération et les contacts électriques sont déposés et brasés lors d'une deuxième opération. En effet, ces contacts sont de dimensions importantes et fabriqués à la demande du client et ceci impose une opération de reprise.

La présente invention a pour but d'éviter cette opération de reprise en déposant et en brasant les contacts électriques en même temps que les composants, donc a l'aide d'une même machine automatique. Il faut alors miniaturiser les contacts jusqu'aux dimensions des composants en ce qui concerne la surface d'emprise sur le circuit.

La présente invention à pour objet un contact électrique pour circuits imprimés équipés de composants montés en surface, assurant une liaison électrique entre ce circuit et un circuit adjacent ou un couvercle, caractérisé en ce qu'il est miniaturisé, sa surface d'emprise sur le circuit étant sensiblement égale à celle des composants, et en ce qu'il comporte une partie base brasée sur le circuit et une partie ressort destinée à venir au contact du circuit adjacent ou du couvercle.

Elle a également pour objet un circuit imprimé équipé de composants montés en surface, comportant au moins un contact électrique, caractérisé en ce que les composants et le ou les contacts sont déposés et brasés sur le circuit en une seule opération.

Il est décrit ci-après, en référence aux dessins annexés, plusieurs exemples de réalisation du contact électrique selon l'invention, ainsi qu'un circuit imprimé comportant un tel contact.

Les figures 1 et 2 représentent deux exemples de réalisa tion dans lesquels le contact est constitué d'une seule pièce.

Les figures 3A et 3B représentent un autre exemple dans lequel le contact est constitué de deux pièces.

Les figures 4 et 5 représentent le contact de la figure 1 monté sur un circuit.

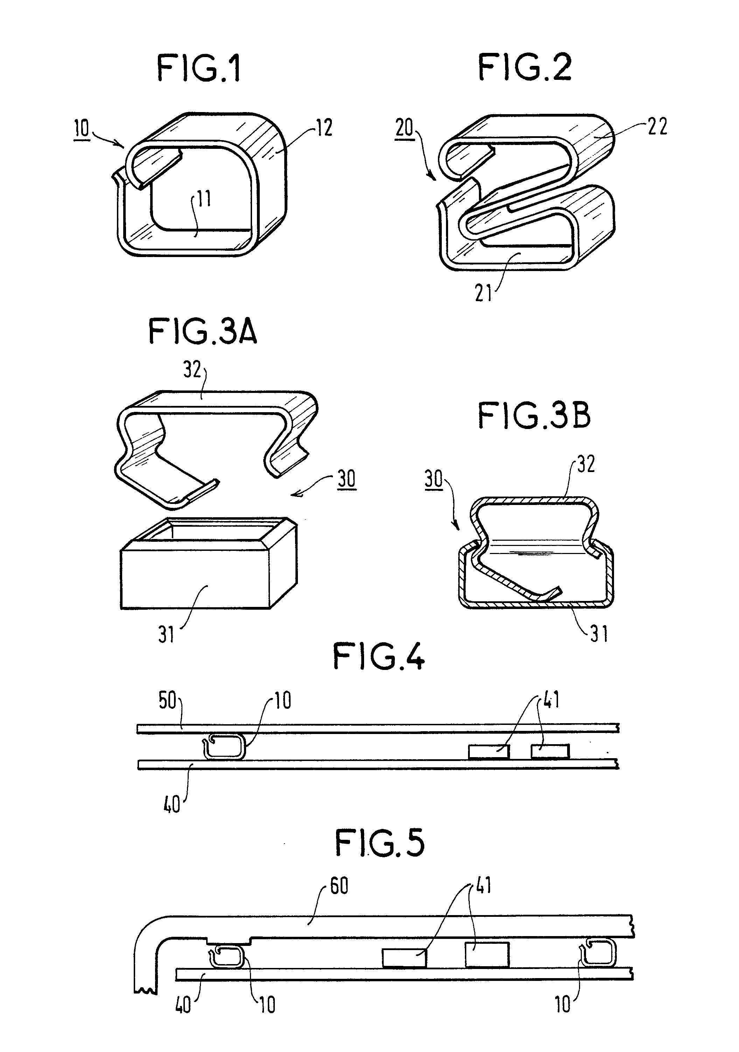

Dans la figure 1, le contact 10 comporte une partie base 11 brasée sur le circuit et une partie ressort 12 qui prend appui sur un circuit adjacent ou un couvercle. Ce contact 10 est constitué d'une seule pièce formant sensiblement une boucle unique.

Dans la figure 2, le contact 20 comporte une partie base 21 et une partie ressort 22. Ce contact 20 est constitué d'une seule pièce formant sensiblement deux boucles, la partie ressort 22 comportant ces deux boucles.

Dans les figures 3A et 3B, le contact 30 est constitué de deux pièces 31, 32, une pièce 31 constituant la partie base et une pièce 32 constituant la partie ressort.

La pièce 31 est une petite boîte dans laquelle s'engage partiellement la pièce 32, comme cela est visible dans la figure 3B.

Les figures 4 et 5 montrent un circuit imprimé 40 muni, sur sa face supérieure, de composants 41 montés en surface et d'un contact électrique 10. Ce contact prend appui, dans la figure 5, sur un circuit adjacent 50 et, dans la figure 6, sur un couvercle 60.

Ces contacts 10, 20, 30 peuvent bien entendu prendre d'autres formes de réalisation particulières. Ils ont des dimensions sensiblement égales aux composants 41, en particulier, leur surface d'emprise sur un circuit est de quelques millimètres-carré, par exemple environ 5 mm² (3,2 mm x 1,6 mm), leur hauteur étant variable.

La matière utilisée pour la fabrication de ces contacts peut être, par exemple, du laiton recouvert d'une fine couche d'or pour assurer une bonne résistance de contact (environ 10 m $\Omega$ ).

Dans tous les exemples de réalisation proposés, la forme du contact permet une bonne préhension par la machine automatique.

La partie base est conçue pour éviter une remontée de brasure qui compromettrait la fonction ressort.

**Revendications**

1/ Contact électrique (10, 20, 30) pour circuits imprimés (40) équipés de composants montés en surface (41), assurant une liaison électrique entre ce circuit et un circuit adjacent (50) ou un couvercle (60), caractérisé en ce qu'il est miniaturisé, sa surface d'emprise sur le circuit étant sensiblement égale à celle des composants (41), et en ce qu'il comporte une partie base (11, 21, 31) brasée sur le circuit et une partie ressort (12, 22, 32) destinée à venir au contact du circuit adjacent (50) ou du couvercle (60).

2. Contact électrique selon la revendication 1, caractérisé en ce que cette surface représente environ 5 mm2.

3/ Contact électrique selon la revendication 1, caractérisé en ce qu'il est constitué d'une seule pièce formant une boucle.

4/ Contact électrique selon la revendication 1, caractérisé en ce qu'il est constitué d'une seule pièce formant deux boucles.

5/ Contact électrique selon la revendication 1, caractérisé en ce qu'il est constitué de deux pièces (31, 32), une pièce constituant la partie base et une pièce constituant la partie ressort.

6/ Circuit imprimé équipé de composants montés en surface, comportant au moins un contact électrique selon l'une des revendications 1 à 5, caractérisé en ce que les composants et le ou les contacts sont déposés et brasés sur le circuit en une seule opération.

EP 0 359 223 A1

FIG.1

FIG.2

FIG.3A

FIG.3B

FIG.4

FIG.5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | EP-A-053968 (CII-HONEYWELL BULL) <br> * page 6, ligne 21 - page 7, ligne 15; figure 1 * | 1, 3, 4 | H01R23/72 <br> H05K7/14 |
| A | FR-A-2534419 (HORLOGERIE PHOTOGRAPHIQUE FRANCAISE) <br> * page 5, ligne 32 - page 6, ligne 23; figure 4 * | 1, 3, 4 | |
| A | I.B.M. TECHNICAL DISCLOSURE BULLETIN <br> vol. 6, no. 10, mars 1964, New York <br> pages 5 - 6; Schick: <br> "Plated through hole contact." <br> * le document en entier * | 5 | |
| A | US-A-4623207 (SASAKI ET AL.) <br> * colonne 3, ligne 59 - colonne 4, ligne 16; figures 3-6 * | 1, 3, 4 | |

DOMAINES TECHNIQUES RECHERCHES (Int. Cl.5 )

H05K
H01R

Le présent rapport a été établi pour toutes les revendications

| Lieu de la recherche | Date d'achèvement de la recherche | Examinateur |
|---|---|---|
| LA HAYE | 31 OCTOBRE 1989 | BARANSKI I. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)